(19) Europäisches Patentamt

European Patent Office

Office européen des brevets

(11) EP 0 508 089 B1

(12) EUROPÄISCHE PATENTSCHRIFT

(45) Veröffentlichungstag und Bekanntmachung des Hinweises auf die Patenterteilung:
29.05.1996 Patentblatt 1996/22

(51) Int Cl.⁶: **G01R 31/06**, G01R 31/00

(21) Anmeldenummer: 92103468.2

(22) Anmeldetag: 28.02.1992

(54) **Verfahren und Einrichtung zur Prüfung einer Armatur**

Process and appliance for testing an armature

Procédé et dispositif pour tester un armature

(84) Benannte Vertragsstaaten:
AT BE CH DE ES FR GB IT LI NL SE

(30) Priorität: 11.03.1991 DE 4107813

(43) Veröffentlichungstag der Anmeldung:
14.10.1992 Patentblatt 1992/42

(73) Patentinhaber: SIEMENS AKTIENGESELLSCHAFT
D-80333 München (DE)

(72) Erfinder:
• Kempf, Burkhard
W-8752 Mömbris (DE)
• Klotz, Hans-Joachim
W-8758 Goldbach (DE)

(56) Entgegenhaltungen:
EP-A- 0 011 952          DE-A- 3 151 757
FR-A- 2 301 830          US-A- 4 319 193

• PATENT ABSTRACTS OF JAPAN vol. 8, no. 38
(P-255)(1475) 18. Februar 1984 & JP-A-58 190 778

**Beschreibung**

Die Erfindung betrifft ein Verfahren zur Prüfung einer durch einen Elektromagneten, der einen Magnetanker aufweist, angetriebenen Armatur, wobei während eines Schaltvorganges der Armatur der Wert der Stromstärke im Magneten zum Zeitpunkt, wenn die Bewegung des Magnetankers der Armatur einsetzt, als Ansprechstromstärke bestimmt wird.

Die Erfindung betrifft auch eine Einrichtung zur Prüfung einer durch einen Elektromagneten, der einen Magnetanker aufweist, angetriebenen Armatur, wobei im Stromkreis des Magneten ein Stromstärkemesser angeordnet ist.

Es ist möglich, daß Armaturen mit Elektromagnetantrieb ihr Betriebsverhalten ändern. Das kann auf Abnutzung mechanisch bewegter Teile zurückzuführen sein. Daraus kann eine Beeinträchtigung des Dichtungsverhaltens und im Extremfall ein Versagen der Armatur folgen.

Es ist daher notwendig, daß alle sicherheitsrelevanten Armaturen wiederholt auf ihre Funktionsfähigkeit hin überprüft werden. Das gilt insbesondere für Armaturen einer Kernreaktoranlage.

Bisher wurde zur Überprüfung der Funktionsfähigkeit einer Armatur der sie versorgende Stromkreis ein- bzw. ausgeschaltet und dann festgestellt, ob die Armatur schließt bzw. öffnet.

Aus der FR -A-2 301 830 kann ein Verfahren nach dem Oberbegriff des Patentanspruches 1 abgeleitet werden. Die in der FR -A-2 301 830 beschriebene Vorrichung ermöglicht, den Ansprechzeitpunkt einer Tauchspule zu bestimmen, indem der Stromstärkenverlauf in der Spule gemessen wird.

Aus den Patent Abstracts of Japan zu JP -A -58 190 778 kann der Oberbegriff des Patentanspruches 10 abgeleitet werden. Aus der japanischen Schrift ist eine Vorrichtung zum Überprüfen eines Relais bekannt, mit der die Stromstärke des durch das Relais fließenden Stromes überwacht wird.

Der Erfindung lag die Aufgabe zugrunde, ein Verfahren zur Prüfung einer Armatur anzugeben, das zur Beurteilung der Funktionsfähigkeit der Armatur eine Größe heranzieht, die eine stets zuverlässige Aussage gestattet. Außerdem sollte eine in gleicher Weise geeignete Einrichtung zur Prüfung einer Armatur angegeben werden.

Die erste Aufgabe wird gemäß der Erfindung dadurch gelöst, daß aus der bestimmen Ansprechstromstärke mittels einer Kalibrierfunktion die auf den Magnetanker zum Zeitpunkt, wenn seine Bewegung einsetzt, durch den Magneten einwirkende Kraft als Ansprechkraft und als Maß für den Zustand der Armatur bestimmt wird.

In der Regel ist der Magnetanker mit einem Verschlußteil der Armatur gekoppelt.

Mittels der zuvor bestimmten Kalibrierfunktion kann vorteilhaft die vom Magneten auf das Verschlußteil einwirkende Kraft für denjenigen Zeitpunkt bestimmt werden, wenn die Bewegung des Verschlußteils einsetzt. Der Wert für diese sogenannte Ansprechkraft kann schnell und zuverlässig mit einfachen Mitteln bestimmt werden. Die Ansprechkraft ist darüber hinaus sehr gut geeignet für eine zuverlässige Aussage über den Zustand der Armatur. Bei einem Abweichen der Ansprechkraft von einem Sollwert ist es notwendig, die überprüfte Armatur zu warten oder sogar auszutauschen.

Zum Bestimmen der Ansprechstromstärke wird beispielsweise während eines Schaltvorgangs der Armatur, wenn z.B. die Nennspannung der Armatur angelegt wird, der Stromstärkeverlauf am Magneten aufgenommen. Aus diesem Verlauf wird als Ansprechstromstärke die Stromstärke bei der ersten Unstetigkeit bestimmt. Das ist möglich, da nach Anlegen einer Spannung an den Magneten der Stromstärkeverlauf zunächst kontinuierlich ansteigt und dann, wenn die Bewegung des Magnetankers/ Verschlußteils einsetzt, eine erste Unstetigkeit aufweist. Der Stromstärkeverlauf weist eine zweite Unstetigkeit auf, wenn die Bewegung des Magnetankers beendet ist. Zwischen den beiden Unstetigkeiten kann der Stromstärkeverlauf für eine kurze Zeitspanne abfallen. Nach der zweiten Unstetigkeit steigt der Stromstärkeverlauf wieder kontinuierlich an, bis er einen konstanten Wert erreicht. Der Stromstärkeverlauf über der Zeit weist also eine erste Unstetigkeit auf, die der Ansprechstromstärke entspricht.

Beispielsweise wird der Stromstärkeverlauf differenziert und die erste Unstetigkeit des differenzierten Stromstärkeverlaufs bestimmt. Die Unstetigkeit des differenzierten Stromstärkeverlaufs ist deutlicher zu erkennen als die Unstetigkeit des Stromstärkeverlaufs. Die Ansprechstromstärke ist dann die Stromstärke zum Zeitpunkt der ersten Unstetigkeit des differenzierten Stromstärkeverlaufs.

Bei üblichen Einschaltvorgängen steigt die Stromstärke schnell an. Dabei treten Wirbelströme auf, die den funktionalen Zusammenhang zwischen Kraft und Stromstärke beeinflussen. Zur Korrektur dieses Einflusses wird die an der zu prüfenden Armatur gemessene Stromstärke um die Wirbelstromstärke vermindert, die abhängig ist von Stromstärke und zeitlicher Änderung der Stromstärke. Die Wirbelstromstärke kann auch andere Verluststromstärken beinhalten.

Um die Wirbelstromstärke zu bestimmen wird beispielsweise neben der Stromstärke auch die Änderung der Stromstärke gemessen. Mit Hilfe eines Korrekturfaktors kann dann die Wirbelstromstärke bestimmt und damit die Stromstärke korrigiert werden.

Mit der Korrektur wird der Vorteil erzielt, daß bei einem schnellen Stromstärkeanstieg im Magneten und selbst bei deutlich von der Nennspannung abweichender Spannung die Kraft auf die beweglichen Teile der Armatur, insbesondere die Ansprechkraft zu bestimmen ist. Beim Anlegen einer großen Spannung ist der Stromstärkeanstieg nämlich größer als beim Anlegen einer kleinen Spannung.

Zum Bestimmen der Ansprechkraft müssen die Kalibrierfunktion und der Korrekturfaktor bereitgestellt sein. Dazu sind Basismessungen erforderlich, die der eigentlichen Prüfung vorausgehen und z.B. in einem Labor durchzuführen sind.

Die Kalibrierfunktion wird z.B. an einer typgleichen Armatur durch Messen der durch einen Magnet auf einen arretierten Magnetanker einwirkenden Kraft in Abhängigkeit von der Stromstärke im Magnet ermittelt.

Zum Ermitteln der Kalibrierfunktion werden beispielsweise an einer typgleichen Armatur bewegliche Teile durch einen Kraftaufnehmer arretiert. Dann wird am Magnet eine elektrische Spannung angelegt, die dann langsam gesteigert wird. Die mit der Spannung steigende Stromstärke und die vom Magnet erzeugte Kraft werden zeitgleich registriert. Die Relation von Kraft und Stromstärke wird in der Kalibrierfunktion ausgedrückt.

Diese Kalibrierfunktion ermöglicht es, für jeden gemessenen Stromstärkewert die momentan wirkende Kraft zu bestimmen, falls keine Wirbelströme auftreten. Mittels der Kalibrierfunktion wird der Vorteil erzielt, daß eine einfache Stromstärkemessung zum Bestimmen der Kraft, insbesondere der Ansprechkraft der Armatur, ausreicht.

Da zum Ermitteln der Kalibrierfunktion eine Armatur eingesetzt wird, die typgleich mit den später zu prüfenden Armaturen ist, ist die Kalibrierfunktion uneingeschränkt zu verwenden. Es muß allerdings für jeden zu prüfenden Armaturentyp eine eigene Kalibrierfunktion aufgenommen werden.

Dadurch, daß die beweglichen Teile der Armatur zum Ermitteln der Kalibrierfunktion durch einen Kraftaufnehmer arretiert werden kann die einwirkende Kraft exakt gemessen werden. Man erhält Kraftwerte nicht nur für Stromstärkewerte unterhalb der Ansprechstromstärke, sondern auch für höhere Stromstärkewerte.

Beispielsweise wird die Kalibrierfunktion als Polynom dargestellt:

$$F = a_0 + a_1 . J + a_2 . J^2 + ... + a_n J^n.$$

Hierbei ist F die Kraft des Magneten auf die beweglichen Teile, J ist die Stromstärke im Magnet und a sind Polynomkoeffizienten. Mit einem Polynom ist die gefundene Kalibrierfunktion gut darstellbar.

Zur Korrektur der Wirbelstromeinflüsse ist auch im Polynom der Kalibrierfunktion, das den funktionalen Zusammenhang zwischen der Kraft auf die beweglichen Teile der Armatur einerseits und der Stromstärke im Magneten der Armatur andererseits darstellt, als Stromstärke J die Differenz aus der gemessenen Stromstärke $J_t$ und der Wirbelstromstärke $J_w$ einzusetzen. Demnach ist für J als wirbelstromkorrigierte Stromstärke $J_k$ einzusetzen:

$$J_k = J_t - J_w$$

Es ist bekannt, daß der Wirbelstrom $J_w$ proportional ist zum gemessenen Strom $I_t$ und zu dessen zeitlicher Änderung $\frac{dJ_t}{dt}$. Daraus folgt:

$$J_w = c . J_t . \frac{dJ_t}{dt} ,$$

wobei c der Korrekturfaktor ist.

Aus den beiden zuvor genannten Beziehungen folgt durch mathematische Umformung für die korrigierte Stromstärke $J_k$

$$J_k = J_t . (1\text{-}c . \frac{dJ_t}{dt} )$$

Diese Gleichung für die korrigierte Stromstärke $J_k$ wird in die Kalibrierfunktion eingesetzt, wodurch man die hinsichtlich des Wirbelstroms korrigierte Kalibrierfunktion erhält, die weiterhin die Form eines Polynoms hat.

Um eine Armatur mit dem Verfahren nach der Erfindung prüfen zu können, ist es noch notwendig, den Korrekturfaktor c zu bestimmen. Dazu wird zunächst in zwei Schritten mit zwei unterschiedlichen konstanten Spannungen, die am Magnet angelegt werden, der Stromstärkeverlauf, der Verlauf der zeitlichen Änderung der Stromstärke und der Kraftverlauf im Einschaltvorgang an der mit einem Kraftaufnehmer arretierten, typgleichen Armatur bestimmt. Man erhält also für jede der beiden Spannungen einen Stromstärkeverlauf, einen Verlauf der Stromstärkeänderung und einen Kraftverlauf über der Zeit.

Im weiteren wird davon ausgegangen, daß bei gleicher Kraft die hinsichtlich des Wirbelstroms korrigierte Stromstärke $J_k$ gleich sein muß. Es werden daher für eine bestimmte, gleiche Kraft die gemessenen Stromstärken $J_t(U_1)$ und $J_t(U_2)$ sowie deren Änderung

$$\left(\frac{dJ_t}{dt}\right) U_1 \quad und \quad \left(\frac{dJ_t}{dt}\right)_{U_2}$$

bestimmt.

Da $J_k(U_1)$ und $J_k(U_2)$ gleich sind, folgt daraus:

$$J_t(U_1) (1 - c . \left(\frac{dJ_t}{dt}\right)_{U_1}) = J_t(U_2) (1 - c . \left(\frac{dJ_t}{dt}\right)_{U_2})$$

Daraus folgt für den Korrekturfaktor:

$$c = \frac{J_t(U_1) - J_t(U_2)}{(J_t \cdot \frac{dJ_t}{dt})_{U_1} - (J_t \cdot \frac{dJ_t}{dt})_{U_2}}$$

Der gefundene Wert für den Korrekturfaktor c ist in die Gleichung für die korrigierte Stromstärke $J_k$ und damit in die Kalibrierfunktion einzusetzen.

Mit Hilfe der Kalibrierfunktion kann allein aus der gemessenen Stromstärke $J_t$ die dazugehörige Kraft K und aus der Ansprechstromstärke $J_A$ die Ansprechkraft $K_A$ bestimmt werden.

Mit dem Verfahren nach der Erfindung wird, insbesondere mit den ergänzenden Korrekturverfahren, der Vorteil erzielt, daß allein mit einer einfachen Stromstärkemessung ein zuverlässiger Hinweis auf den Zustand einer Armatur gegeben werden kann.

Die zweite gestellte Aufgabe, eine zuverlässige und einfach arbeitende Einrichtung zur Prüfung einer Armatur anzugeben, wird gemäß der Erfindung dadurch gelöst, daß der Stromstärkemesser mit einer Auswahleinheit zum Bestimmen der Stromstärke im Stromkreis des Magneten im Maximum bzw. an einer Unstetigkeit des Stromstärkeverlaufs oder des nach der Zeit differenzierten Stromstärkeverlaufs verbunden ist, daß die Auswahleinheit mit einem Rechner verbunden ist, daß ein Speicher für eine Kalibrierfunktion vorhanden ist, die die Abhängigkeit der auf den Magnetanker einwirkenden Kraft von der Stromstärke im Stromkreis des Magneten angibt, und daß der Speicher mit dem Rechner in Verbindung steht.

Im Rechner wird die gemessene Stromstärke mit der gespeicherten Kalibrierfunktion verknüpft, so daß am Ausgang des Rechners ein Wert für die Kraft ansteht. Dieser Wert wird mit einem Sollwert auf Abweichung verglichen, und bei einer Abweichung wird beispielsweise durch einen Signalgeber ein Signal abgegeben. Der Speicher für die Kalibrierfunktion kann auch ein beweglicher Speicher, z.B. eine Diskette, sein.

Beispielsweise ist der Rechner mit einer Anzeigevorrichtung, z.B. mit einem Bildschirm oder mit einem Plotter verbunden, die den zeitlichen Verlauf der Stromstärke oder der differenzierten Stromstärke darstellen können. Eine auf der Anzeigevorrichtung gezeigte Unstetigkeitsstelle oder ein Maximum werden von einer Person als Einschaltzeitpunkt erkannt.

Dazu kann ein Cursor dienen. Der Wert der Stromstärke zum Einschaltzeitpunkt wird im Rechner bestimmt. Für diese Einschaltstromstärke wird dann die Kraft im Einschaltzeitpunkt (Ansprechkraft) berechnet.

Die Einschaltstromstärke kann auch automatisiert aus dem gemessenen Stromstärkeverlauf durch einen Rechner ermittelt werden, ohne daß eine Person den Stromstärkeverlauf untersucht.

Mit der ergänzten Einrichtung wird als Ansprechkraft diejenige Kraft untersucht, die auf bewegliche Teile der Armatur dann einwirkt, wenn die Bewegung einsetzt. Diese Kraft gibt einen optimalen Hinweis auf den Zustand der Armatur.

Zur Korrektur des Einflusses eines Wirbelstroms auf die gemessene Stromstärke dient ein Subtrahierglied, das dem Stromstärkemesser nachgeschaltet in der Regel im Rechner integriert ist. Dem zweiten Eingang des Subtrahierglieds ist der zugeordnete Wirbelstromwert zugeleitet. Zum Bestimmen dieses Wirbelstromwerts steht der Stromstärkemesser mit einem Rechner in Verbindung, dem auch ein Korrekturfaktor zuführbar ist. Aus diesem, sowie aus dem Stromstärkewert und der differenzierten Stromstärke wird im Rechner der Wirbelstromwert bestimmt.

Zum Ermitteln der notwendigen Kalibrierfunktion dient eine z.B. in einem Labor angeordnete Kalibriereinrichtung. Diese weist eine typgleiche Armatur auf, deren bewegliche Teile, insbesondere deren Magnetanker oder Verschlußteil, durch einen Kraftaufnehmer arretiert sind. Der Magnet der typgleichen Armatur ist mit einem variablen Spannungsgeber verbunden. Im Stromkreis des Magneten befindet sich ein Stromstärkemesser. Im übrigen entspricht die Kalibriereinrichtung weitgehend der Einrichtung, die zum Prüfen einer Armatur eingesetzt wird. Es können automatisch oder manuell unterschiedliche Spannungen angelegt werden. Dann wird für jeden Spannungswert ein Wertepaar aus Stromstärke und Kraft bestimmt und aus den Wertepaaren die Kalibrierfunktion in einem Korrelierglied gebildet, das Teil eines Rechners sein kann. Dem Korrelierglied ist der bereits erwähnte Speicher für die Kalibrierfunktion nachgeordnet. Der Speicher kann ein transportabler Speicher, wie z.B. eine Diskette, sein.

Zum Bestimmen des Korrekturfaktors sind beispielsweise der Kraftaufnehmer direkt und der Stromstärkemesser der erwähnten typgleichen Armatur direkt und über ein Differenzierglied mit Speichern verbunden zum Abspeichern der Stromstärkeverläufe, der Verläufe der Stromstärkeänderung und der Kraftverläufe im Einschaltvorgang für zwei unterschiedliche, konstante Spannungen. Die Speicher sind mit einer Auswahl- und Recheneinheit verbunden zum Auswählen der Stromstärken und Stromstärkeänderungen für die beiden Spannungen bei einer konstanten Kraft und zum Berechnen des Korrekturfaktors. Differenzierglied, Speicher und Auswahl- und Recheneinheit können Teil eines Rechners zum Bestimmen des Korrekturfaktors sein. Der Auswahl- und Recheneinheit bzw. dem Rechner ist ein Speicher für den Korrekturfaktor, z.B. ein transportabler Speicher, z.B. eine Diskette, nachgeodnet.

Der Korrekturfaktor kann auch für die spätere Verwendung auf einem Datenträger abgespeichert sein.

Mit der Einrichtung gemäß der Erfindung zur Prüfung einer durch einen elektrischen Magneten angetriebenen Armatur wird der Vorteil erzielt, daß nach erfolgter Kalibrierung nur der Stromstärkeverlauf am Magneten gemessen zu werden braucht. Man erhält trotzdem eine zuverlässige Aussage über die auf die beweglichen Teile der Armatur einwirkende Kraft zum Zeitpunkt des Bewegungsbeginns. Diese Kraft gestattet eine eindeutige Aussage über den momentanen Zustand der Armatur.

Das Verfahren und die Einrichtung nach der Erfindung wird anhand der Zeichnung näher erläutert:

Figur 1   zeigt den Verlauf der Stromstärke $J_t$ am Magnet einer magnetisch angetriebenen Armatur beim Einschaltvorgang über der Zeit t;

Figur 2   zeigt ein Schaltbild einer Einrichtung zur Prüfung einer durch einen elektrischen Magnet angetriebenen Armatur;

Figur 3   zeigt ein Schaltbild einer Laboreinrichtung zur Bereitstellung einer Kalibrierfunktion und eines Korrekturfaktors.

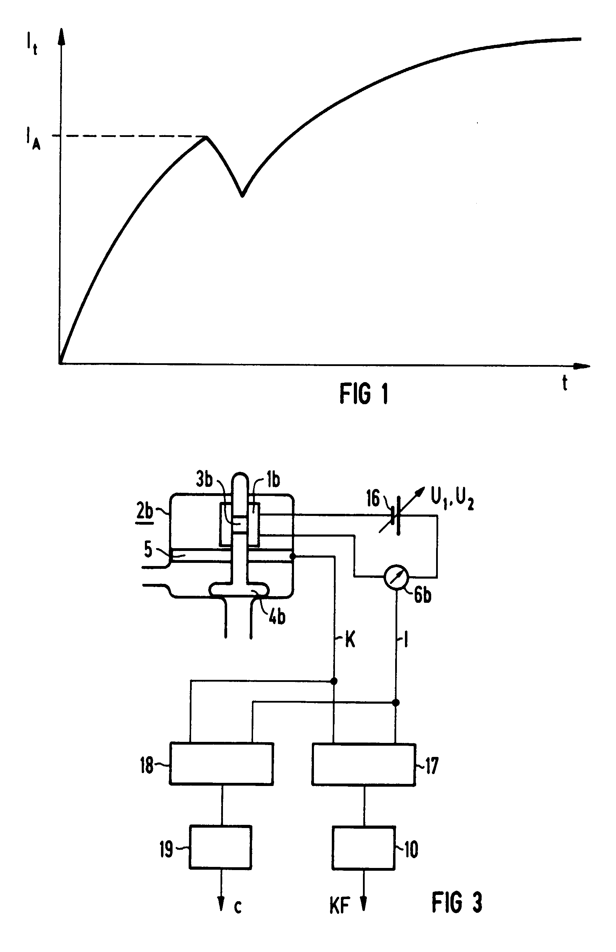

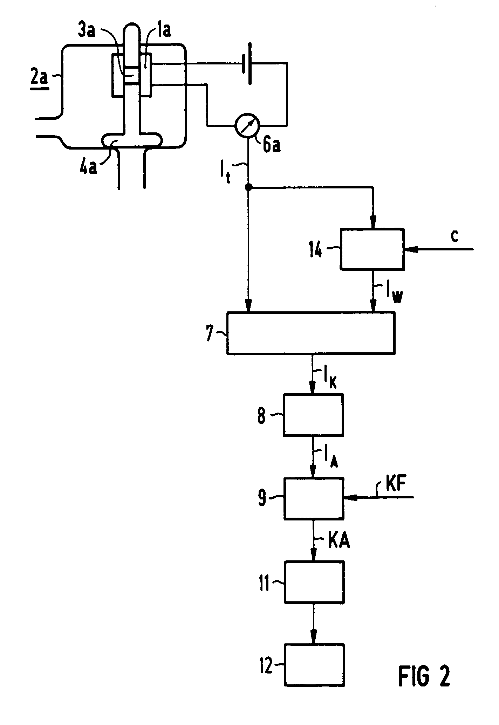

Wenn eine Spannung an den Magnet la (Figur 2) einer magnetgetriebenen Armatur 2a angelegt wird, steigt gemäß Figur 1 die Stromstärke $J_t$ im Stromkreis des Magneten la zunächst an. Wenn die Bewegung der beweglichen Teile, z.B. des Magnetankers 3a oder des Verschlußteils 4a der Armatur 2a einsetzt, fällt die Stromstärke $J_t$ kurzzeitig ab oder steigt nach einer Unstetigkeit weniger schnell als zuvor an. Danach steigt die Stromstärke $J_t$ nach einer weiteren Unstetigkeit wieder wie zuvor an und erreicht einen konstanten Wert. Um die sogenannte Ansprechstromstärke $J_A$, das ist die Stromstärke zu dem Zeitpunkt, wenn die Bewegung der beweglichen Teile der Armatur 2a einsetzt, zu bestimmen, reicht es aus, die erste Unstetigkeit bzw. das Maximum im Stromstärkeverlauf zu bestimmen. Dazu wird der Stromstärkeverlauf differenziert und dann dort die erste Unstetigkeit oder der Nulldurchgang bestimmt. Aus der Ansprechstromstärke $J_A$ wird mit einer Kalibrierfunktion KF die beim Ansprechen der Armatur 2a einwirkende Kraft $K_A$ bestimmt, die einen optimalen Hinweis auf die Funktionsfähigkeit der Armatur 2a gibt.

Zum Bestimmen der Kalibrierfunktion KF und des Korrekturfaktors c dient eine typgleiche Armatur 2b, bei der die beweglichen Teile, z.B. das Verschlußteil 4b und der Magnetanker 3b durch einen Kraftaufnehmer 5 blockiert sind.

Zur Verbesserung der Auswertegenauigkeit kann eine Korrektur der Wirbelstromeinflüsse erfolgen.

Gemäß Figur 2 weist die Einrichtung zur Armaturenprüfung nach der Erfindung einen Stromstärkemesser 6a im Magnetstromkreis der zu prüfenden Armatur 2a auf. Zur Korrektur der Wirbelstromeinflüsse ist der Stromstärkemesser 6a mit einem Subtrahierglied 7 verbunden, dessen anderer Eingang einen Wirbelstromstärkewert $I_w$ aufnimmt. Am Ausgang des Subtrahierglieds 7 steht die korrigierte Stromstärke $J_k$ an. Zum Bestimmen der Ansprechstromstärke $J_A$ der Armatur 2a, bei der die Bewegung der Armatur 2a beginnt, ist der Ausgang des Subtrahierglieds 7 mit einer Auswahleinheit 8 verbunden. In der Auswahleinheit 8 wird das Maximum bzw. eine Unstetigkeit des Stromstärkeverlaufs gemäß Figur 1 oder des differenzierten Stromstärkeverlaufs bestimmt. Am Ausgang der Auswahleinheit 8 steht die hinsichtlich des Wirbelstroms korrigierte Ansprechstromstärke $J_A$ an. Der Ausgang der Auswahleinheit 8 ist mit einem Rechner 9 verbunden, dem von einem Speicher 10 die Kalibrierfunktion KF zuführbar ist. An die Stelle der Auswahleinheit 8 kann auch ein Bildschirm oder ein Zeichengerät treten, mit dessen Hilfe dann eine Person die Auswahl der Ansprechstromstärke $J_A$ vornimmt. Die Ansprechstromstärke $J_A$ muß dann in den Rechner 9 eingelesen werden. Am Ausgang des Rechners 9 steht die der Ansprechstromstärke $J_A$ entsprechende Ansprechkraft $K_A$ auf die beweglichen Teile, z.B. auf das Verschlußteil 4a der Armatur 2a an. Der Ausgang des Rechners 9 ist z.B. über ein Sollwertvergleichsteil 11 z.B. mit einem Signalgeber 12 verbunden, der eine Abweichung des Kraftwertes von einem Sollwert anzeigt und damit einen Hinweis auf den Zustand der Armatur 2a gibt. Das Subtrahierglied 7, die Auswahleinheit 8, bzw. der Bildschirm und der Rechner 9 etc. können zusammen einen übergeordneten Rechner bilden.

Zur Berechnung der Wirbelstromstärke $J_w$ steht der stromstärkemesser 1 mit einem zusätzlichen Rechner 14 in Verbindung, der ein Differenzierglied enthält und dem ein Korrekturfaktor c zuführbar ist. Dieser Rechner 14 kann Teil des übergeordneten Rechners sein.

Gemäß Figur 3 dient zum Bestimmen der Kalibrierfunktion KF im Labor eine Armatur 2b, die typgleich mit der zu prüfenden Armatur 2a ist. In dieser typgleichen Armatur 2b sind die beweglichen Teile, z.B. das Verschlußteil 4b oder der Magnetanker 3b durch einen Kraftaufnehmer 5 blockiert. Im Stromkreis des Magneten 1b befindet sich ein Stromstärkemesser 6b und ein variabler Spannungsgeber 16. Kraftaufnehmer 5 und Stromstärkemesser 6b stehen beide mit einem Korrelierglied 17 in Verbindung, in dem aus gemessenen Wertepaaren für die Kraft K und die Stromstärke J die Kalibrierfunktion KF bestimmt wird. Das Korrelierglied 17 ist mit dem Speicher 10 für die Kalibrierfunktion KF verbunden. Das Korrelierglied 17 kann ein Rechner sein.

Zum Bestimmen des Korrekturfaktors c, der zum Bestimmen der Wirbelstromstärke $J_w$ notwendig ist, sind der Stromstärkemesser 6b und der Kraftaufnehmer 5 der typgleichen Armatur 2b, die bereits zum Bestimmen der Kalibrierfunktion KF dient, mit einem Labor-Rechner 18 verbunden. Dort werden für zwei unterschiedliche, vom Spannungsgeber 16 erzeugte Spannungen $U_1$ und $U_2$ Stromstärkeverläufe, differenzierte Stromstärkeverläufe und Kraftverläufe abgespeichert. Für eine bestimmte feste Kraft werden aus den beiden Stromstärkeverläufen die zugehörigen beiden Stromstärken $Ju_1$ und $Ju_2$ ausgewählt. Aus den beiden differenzierten Stromstärkeverläufen werden die entsprechenden Stromstärkeänderungen $(\frac{dJ}{dt})u_1$ und $(\frac{dJ}{dt})u_2$ ausgewählt. Aus den genannten Werten wird der Korrekturfaktor c bestimmt, der für die Wirbelstromkorrektur notwendig ist. Der Ausgang des Rechners 18 ist mit einem Korrekturwertspeicher 19 verbunden. Der Rechner 18 kann das Korrelierglied 17 enthalten. Der Rechner 18 kann einen Bildschirm oder ein Zeichengerät aufweisen, mit dessen Hilfe dann eine Person die Werte für die Stromstärke $J_{u1}$ und $J_{u2}$ und für die Stromstärkeänderung $(\frac{dJ}{dt})_{u_1}$ und $(\frac{dJ}{dt})_{u_2}$ von Kurven abliest. Diese Werte müssen dann in den Rechner 18 eingegeben werden. Der Labor-Rechner 18 kann baugleich mit einem Rechner sein, der bei der Prüfung an der Armatur 2a eingesetzt wird.

Mit dem Verfahren und mit der gezeigten Einrichtung zur Prüfung einer Armatur 2a kann vorteilhaft nach dem Bestimmen der Kalibrierfunktion KF und des Korrekturfaktors c allein aus der mit einfachen Mitteln zu messenden Stromstärke $J_t$ im Stromkreis des Magneten la zuverlässig und genau die beim Ansprechen der Armatur 2a wirkende Kraft $K_A$ auf die beweglichen Teile, z.B. auf das Verschlußteil 4a, der Armatur 2a bestimmt werden. Diese Ansprechkraft $K_A$ gestattet eine eindeutige Aussage über den Zustand der Armatur 2a.

Im gesamten Text ist für die Stromstärke J mit I und für die Ansprechkraft $K_A$ mit KA gleichzusetzen.

**Patentansprüche**

1. Verfahren zur Prüfung einer durch einen Elektro-Magneten (1a), der einen Magnetanker (3a) aufweist, angetriebenen Armatur (2a), wobei während eines Schaltvorgangs der Armatur (2a) der Wert der Stromstärke ($I_t$) im Magneten (1a) zum Zeitpunkt, wenn die Bewegung des Magnetankers (3a) der Armatur (2a) einsetzt, als Ansprechstromstärke ($I_A$) bestimmt wird, **dadurch gekennzeichnet**, daß aus der bestimmten Ansprechstromstärke ($I_A$) mittels einer Kalibrierfunktion (KF) die auf den Magnetanker (3a) zum Zeitpunkt, wenn seine Bewegung einsetzt, durch den Magneten (1a) einwirkende Kraft als Ansprechkraft (KA) und als Maß für den Zustand der Armatur (2a) bestimmt wird.

2. Verfahren nach Anspruch 1,
   **dadurch gekennzeichnet**, daß während eines Schaltvorgangs der Armatur (2a) der Verlauf der Stromstärke ($I_t$) am Magneten (1a) aufgenommen wird, und daß als Ansprechstromstärke ($I_A$) die Stromstärke bei der ersten Unstetigkeit des Verlaufs der Stromstärke ($I_t$) bestimmt wird.

3. Verfahren nach Anspruch 2,
   **dadurch gekennzeichnet**, daß der Verlauf der Stromstärke ($I_t$) differenziert wird und als Ansprechstromstärke ($I_A$) die Stromstärke bei der ersten Unstetigkeit des ,differenzierten Verlaufs der Stromstärke ($I_t$) bestimmt wird.

4. Verfahren nach einem der Ansprüche 1 bis 3,
   **dadurch gekennzeichnet**, daß die Kalibrierfunktion (KF) an einer typgleichen Armatur (2b) durch Messen der durch einen Magneten (1b) auf einen arretierten Magnetanker (3b) einwirkenden Kraft (K) in Abhängigkeit von der Stromstärke (I) im Magnet (1b) ermittelt wird.

5. Verfahren nach Anspruch 4,
   **dadurch gekennzeichnet**, daß zum Ermitteln der Kalibrierfunktion (KF) an der typgleichen Armatur (2b) der Magnetanker (3b) durch einen Kraftaufnehmer (5) blockiert ist, daß am Magneten (1b) eine elektrische Spannung angelegt wird, die dann langsam gesteigert wird, daß die Stromstärke (I) des durch die angelegte Spannung erzeugten Stromes und die vom Kraftaufnehmer (5) gemessene Kraft (K) zeitgleich registriert werden, und daß als Kalibrierfunktion (KF) die Kraft (K) in Relation zum Strom (I) bestimmt wird.

6. Verfahren nach einem der Ansprüche 1 bis 5,
   **dadurch gekennzeichnet**, daß die Kalibrierfunktion (KF) als Polynom dargestellt wird.

7. Verfahren nach einem der Ansprüche 1 bis 6,
   **dadurch gekennzeichnet**, daß zur Korrektur des Einflusses eines Wirbelstroms ($I_W$) die gemessene Stromstärke ($I_t$) um die Wirbelstromstärke ($I_W$) vermindert wird, die proportional zur gemessenen Stromstärke ($I_t$) und zur zeitlichen Änderung der gemessenen Stromstärke ist.

8. Verfahren nach Anspruch 7,
   **dadurch gekennzeichnet**, daß die Wirbelstromstärke ($I_W$) bestimmt wird aus der gemessenen Stromstärke ($I_t$)

der zeitlichen Änderung der gemessenen Stromstärke und aus einem Korrekturfaktor (c).

9. Verfahren nach Anspruch 8,
   **dadurch gekennzeichnet**, daß zur Bestimmung des Korrekturfaktors (c) bei durch einen Kraftaufnehmer (5) blokkierter typgleicher Armatur (2b) nacheinander zwei unterschiedliche, konstante Spannungen ($U_1$, $U_2$) am Magneten (1b) angelegt werden, und daß jeweils im Einschaltvorgang der Verlauf der Stromstärke (I), der zeitlichen Änderung der Stromstärke und vom Kraftaufnehmer (5) der Verlauf der Kraft (K) gemessen werden, daß für beide konstanten Spannungen für eine gleichgroße Kraft (K) aus den Verläufen der Stromstärke (I) die momentanen Stromstärken und die momentanen zeitlichen Stromstärkeänderungen bestimmt werden, und daß aus diesen beiden Wertepaaren der Korrekturfaktor (c) bestimmt wird.

10. Einrichtung zur Prüfung einer durch einen Elektromagneten (1a), der einen Magnetanker (3a) aufweist, angetriebenen Armatur (2a), wobei im Stromkreis des Magneten (1a) ein Stromstärkemesser (6a) angeordnet ist,
    **dadurch gekennzeichnet**, daß der Stromstärkemesser (6a) mit einer Auswahleinheit (8) zum Bestimmen der Stromstärke ($I_A$) im Stromkreis des Magneten (1a) im Maximum bzw. an einer Unstetigkeit des Stromstärkeverlaufs oder des nach der Zeit differenzierten Stromstärkeverlaufs verbunden ist, daß die Auswahleinheit (8) mit einem Rechner (9) verbunden ist, daß ein Speicher (10) für eine Kalibrierfunktion (KF) vorhanden ist, die die Abhängigkeit der auf den Magnetanker (3a) einwirkenden Kraft (K) von der Stromstärke (I) im Stromkreis des Magneten (1a) angibt, und daß der Speicher (10) mit dem Rechner (9) in Verbindung steht.

11. Einrichtung nach Anspruch 10,
    **dadurch gekennzeichnet**, daß zum Ermitteln der Kalibrierfunktion (KF) eine typgleiche Armatur (2b) vorhanden ist, deren Magnetanker (3b) durch einen Kraftaufnehmer (5) arretiert ist, daß ein Magnet (1b) der typgleichen Armatur (2b) mit einer variablen Spannungsquelle (16) verbunden ist, daß im Stromkreis des Magneten (1b) ein Stromstärkemesser (6b) angeordnet ist, und daß der Kraftaufnehmer (5) und der Stromstärkemesser (6b) der typgleichen Armatur (2b) mit einem Korrelierglied (17) zur Bildung der Kalibrierfunktion (KF) verbunden sind, das mit dem Speicher (10) für die Kalibrierfunktion (KF) verbunden ist.

12. Einrichtung nach einem der Ansprüche 10 oder 11,
    **dadurch gekennzeichnet**, daß zur Korrektur des Einflusses eines Wirbelstromes ($I_W$) der Stromstärkemesser (6a) mit einem ersten Eingang eines Subtrahiergliedes (7) verbunden ist und daß der Stromstärkemesser (6a) mit einem zusätzlichen Rechner (14), der ein differenzierglied enthält, verbunden ist, wobei dem zusätzlichen Rechner (14) ein Korrekturfaktor (c) zuführbar ist, daß der Ausgang des zusätzlichen Rechners (14), an dem der Wert für den Wirbelstrom ($I_w$) ansteht, mit einem zweiten Eingang des Subtrahiergliedes (7) verbunden ist, und daß das Subtrahierglied (7), an dessen Ausgang die korrigierte Stromstärke ($I_K$) ansteht, mit der Auswahleinheit (8) in Verbindung steht.

13. Einrichtung nach Anspruch 12,
    **dadurch gekennzeichnet**, daß zum Ermitteln des Korrekturfaktors (c) der Kraftaufnehmer (5) und der Stromstärkemesser (6b) der typgleichen Armatur (2b) mit einem Laborrechner (18) verbunden sind zum Abspeichern des Verlaufs der Stromstärke (I), der zeitlichen Stromstärkeänderung und der Kraft (K) im Einschaltvorgang für zwei unterschiedliche, konstante Spannungen ($U_1$, $U_2$), zum Auswählen von je einer Stromstärke und einer zeitlichen Stromstärkeänderung für eine konstante Kraft (K) für jede der beiden Spannungen ($U_1$, $U_2$) und zum Berechnen des Korrekturfaktors (c) aus den Stromstärken und den zeitlichen Stromstärkeänderungen für zwei Spannungswerte ($U_1$, $U_2$) und für eine konstante Kraft (K), und daß der Ausgang des Laborrechners (18) zur Bereitstellung des Korrekturfaktors (c) mit einem Speicher (19) für den Korrekturfaktor (c) verbunden ist.

**Claims**

1. Method of testing a valve (2a) operated by an electromagnet (1a) which has a magnet armature (3a), wherein during a switching operation of the valve (2a) the value of the current intensity ($I_t$) in the magnet (1a) at the instant when the movement of the magnet armature (3a) of the valve (2a) begins is determined as a response current intensity ($I_A$), characterized in that a calibration function (KF) is used to determine from the specific response current intensity ($I_A$) the force, which is exerted by the magnet (1a) upon the magnet armature (3a) at the instant when the latter's movement begins, as a response force (KA) and as a measure of the state of the valve (2a).

2. Method according to claim 1, characterized in that during a switching operation of the valve (2a) the characteristic of the current intensity ($I_t$) at the magnet (1a) is detected, and that the current intensity upon the first discontinuity of the characteristic of the current intensity ($I_t$) is determined as a response current intensity ($I_A$).

3. Method according to claim 2, characterized in that the characteristic of the current intensity ($I_t$) is differentiated and the current intensity upon the first discontinuity of the differentiated characteristic of the current intensity ($I_t$) is determined as a response current intensity ($I_A$) .

4. Method according to one of claims 1 to 3, characterized in that the calibration function (KF) is determined using a valve (2b) of an identical type by measuring the force (K), which is exerted by a magnet (1b) upon an arrested magnet armature (3b), as a function of the current intensity (I) in the magnet (1b).

5. Method according to claim 4, characterized in that, for determining the calibration function (KF), the magnet armature (3b) of the identical-type valve (2b) is blocked by means of a force pick-up (5), that a voltage is applied to the magnet (1b) and then slowly increased, that the current intensity (I) of the current generated by the applied voltage and the force (K) measured by the force pick-up (5) are isochronously recorded, and that the force (K) in relation to the current (I) is determined as a calibration function (KF).

6. Method according to one of claims 1 to 5, characterized in that the calibration function (KF) is presented as a polynomial.

7. Method according to one of claims 1 to 6, characterized in that, for correcting the influence of an eddy current ($I_w$), the measured current intensity ($I_t$) is reduced by the eddy current intensity ($I_w$), which is proportional to the measured current intensity ($I_t$) and to the variation with time of the measured current intensity.

8. Method according to claim 7, characterized in that the eddy current intensity ($I_w$) is determined from the measured current intensity ($I_t$), the variation with time of the measured current intensity and a correction factor (c).

9. Method according to claim 8, characterized in that, for determining the correction factor (c), in an identical-type valve (2b) blocked by means of a force pick-up (5) two different constant voltages ($U_1$, $U_2$) are successively applied to the magnet (1b), and that in each case during the switch-on operation the characteristic of the current intensity (I), the characteristic of the variation with time of the current intensity and, by the force pick-up (5), the characteristic of the force (K) are measured, that for both constant voltages for an equal force (K) the instantaneous current intensities and the instantaneous variations with time of the current intensity are determined from the characteristics of the current intensity (I), and that the correction value (c) is determined from said two pairs of values.

10. Device for testing a valve (2a) operated by an electromagnet (1a) which has a magnet armature (3a), wherein a current intensity meter (6a) is disposed in the circuit of the magnet (1a), characterized in that the current intensity meter (6a) is connected to a selection unit (8) for determining the current intensity ($I_A$) in the circuit of the magnet (1a) at the maximum point or at a discontinuity of the current intensity characteristic or the time-differentiated current intensity characteristic, that the selection unit (8) is connected to a computer (9), that a memory (10) is provided for a calibration function (KF) which indicates the dependency of the force (K), which is exerted on the magnet armature (3a), upon the current intensity (I) in the circuit of the magnet (1a), and that the memory (10) is connected to the computer (9).

11. Device according to claim 10, characterized in that, for determining the calibration function (KF), a valve (2b) of an identical type is provided, the magnet armature (3b) of which is arrested by means of a force pick-up (5), that a magnet (1b) of the identical-type valve (2b) is connected to a variable voltage source (16), that a current intensity meter (6b) is disposed in the circuit of the magnet (1b), and that the force pick-up (5) and the current intensity meter (6b) of the identical-type valve (2b) are connected to a correlator (17) for forming the calibration function (KF), which correlator is connected to the memory (10) for the calibration function (KF).

12. Device according to one of claims 10 or 11, characterized in that, for correcting the influence of an eddy current ($I_w$), the current intensity meter (6a) is connected to a first input of a subtractor (7) and that the current intensity meter (6a) is connected to an additional computer (14) containing a differentiator, a correction factor (c) being suppliable to the additional computer (14), that the output of the additional computer (14) at which the value for the eddy current ($I_w$) is present is connected to a second input of the subtractor (7), and that the subtractor (7), at the output of which the corrected current intensity ($I_K$) is present, is connected to the selection unit (8).

**13.** Device according to claim 12, characterized in that, for determining the correction factor (c), the force pick-up (5) and the current intensity meter (6b) of the identical-type valve (2b) are connected to a laboratory computer (18) for storing the characteristic of the current intensity (I), of the current intensity variation with time and of the force (K) during the switch-on operation for two different constant voltages ($U_1$, $U_2$), for selecting one current intensity and one current intensity variation with time for a constant force (K) for each of the two voltages ($U_1$, $U_2$) and for calculating the correction factor (c) from the current intensities and the current intensity variations with time for two voltage values ($U_1$, $U_2$) and for a constant force (K), and that the output of the laboratory computer (18) for providing the correction factor (c) is connected to a memory (19) for the correction factor (c).

## Revendications

**1.** Procédé pour tester une armature (2a) entraînée par un électro-aimant (1a), présentant un court-circuit magnétique (3a), pour lequel pendant une opération de commutation de l'armature (2a), la valeur de l'intensité du courant ($I_t$) de l'aimant (1a) est définie en tant qu'intensité du courant de réponse ($I_A$) au moment où le mouvement du court-circuit magnétique (3a) de l'armature (2a) est déclenché, caractérisé en ce qu'à partir de l'intensité de réponse définie ($I_A$), la force agissant par l'aimant (1a) sur le court-circuit magnétique (3a) au moment où son mouvement se déclenche, est définie au moyen d'une fonction d'étalonnage (KF) comme force de réponse (KA) et mesure de l'état de l'armature (2a).

**2.** Procédé selon la revendication 1, caractérisé en ce que pendant une opération de commutation de l'armature (2a), on enregistre la courbe de l'intensité de courant ($I_t$) sur l'aimant (1a) et en ce qu'on définit comme intensité de courant de réponse ($I_A$) l'intensité de courant lors de la première discontinuité de la courbe de l'intensité de courant ($I_t$).

**3.** Procédé et dispositif selon la revendication 2, caractérisés en ce que la courbe de l'intensité de courant ($I_t$) est différenciée et l'intensité de courant lors de la première discontinuité de la courbe différenciée de l'intensité ($I_t$) est définie en tant qu'intensité du courant de réponse ($I_A$).

**4.** Procédé selon les revendications 1 à 3, caractérisé en ce que la fonction d'étalonnage (KF) est obtenue sur une armature de type analogue (2b) en mesurant la force agissant (K) par un aimant (1b) sur un court-circuit magnétique arrêté (3b), en fonction de l'intensité de courant (I) dans l'aimant (1b).

**5.** Procédé selon la revendication 4, caractérisé en ce que pour obtenir la fonction d'étalonnage (KF) sur l'armature de type analogue (2b), on bloque le court-circuit magnétique (3b) par un transducteur de force (5), en ce qu'une tension électrique lentement augmentée est appliquée à l'aimant (1b), en ce que l'intensité (I) du courant produit par la tension appliquée et la force (K) mesurée par le transducteur de force (K) sont enregistrées simultanément et en ce que la force (K) en relation avec le courant (I) est déterminée en tant que fonction d'étalonnage (KF).

**6.** Procédé selon l'une des revendications 1 à 5, caractérisé en ce que la fonction d'étalonnage (KF) est représentée sous forme de polynôme.

**7.** Procédé selon l'une des revendications 1 à 6, caractérisé en ce que pour corriger l'effet d'un courant de Foucault ($I_W$) l'intensité mesurée ($I_t$) est réduite de l'intensité du courant de Foucault ($I_W$) qui est proportionnelle à l'intensité ($I_t$) mesurée et à la variation temporaire de l'intensité mesurée.

**8.** Procédé selon la revendication 7, caractérisé en ce que l'intensité de courant de Foucault ($I_W$) est déterminée à partir de l'intensité mesurée ($I_t$), de la variation temporaire de l'intensité mesurée et à partir d'un facteur de correction (c).

**9.** Procédé selon la revendication 8 caractérisé en ce que pour déterminer le facteur de correction (c) pour une armature (2b) de type analogue bloquée par un transducteur de force (5), on applique l'une après l'autre deux tensions différentes constantes ($U_1, U_2$) à l'aimant (1b) et en ce qu'à chaque opération de commutation on mesure la courbe de l'intensité (I), de la variation temporaire de l'intensité et la courbe de la force (K) à partir du transducteur de force (5), en ce qu'on détermine à partir des courbes de l'intensité de courant (I) les intensités de courant provisoires et les variations d'intensité temporaires provisoires pour les deux tensions constantes pour une force (K) de même valeur et en ce qu'on détermine le facteur de correction (c) à partir de ces deux paires de valeurs.

10. Dispositif pour tester une armature (2a) entraînée par un électro-aimant (1a), présentant un court-circuit magnétique (3a), pour lequel un ampèremètre (6a) est monté dans le circuit de l'aimant (1a), caractérisé en ce que l'ampèremètre (6a) est relié à un sélecteur (8) pour déterminer l'intensité de courant ($I_A$) dans le circuit de l'aimant (1a) au maximum respectivement sur une discontinuité de la courbe d'intensité de courant ou de la courbe d'intensité de courant différenciée en fonction du temps, en ce que le sélecteur (8) est relié à un ordinateur (9), en ce qu'il existe une mémoire (10) pour une fonction d'étalonnage (KF) qui indique la dépendance de la force (K) agissant sur le court-circuit magnétique (3a) de l'intensité de courant (I) dans le circuit de l'aimant (1a) et en ce que la mémoire (10) est reliée à l'ordinateur (9).

11. Dispositif selon la revendication 10 caractérisé en ce que pour obtenir la fonction d'étalonnage (KF) on dispose d'une armature de type analogue (2b) dont le court-circuit magnétique (3b) est arrêté par un transducteur de force (5), en ce qu'un aimant (1b) de l'armature de type analogue (2a) est relié à une source de tension variable (16), en ce qu'un ampèremètre (6b) est monté dans le circuit de l'aimant (1b) et en ce que le transducteur de force (5) et l'ampèremètre (6b) de l'armature de type analogue (2b) sont reliés à un élément de corrélation (17) pour former la fonction d'étalonnage (KF), qui est relié à la mémoire (10) pour la fonction d'étalonnage (KF).

12. Dispositif selon l'une des revendications 10 ou 11 caractérisé en ce que pour corriger l'effet d'un courant de Foucault ($I_W$), l'ampèremètre (6a) est relié à une première entrée d'un élément soustracteur (7) et en ce que l'ampèremètre (6a) est relié à un calculateur supplémentaire (14) contenant un élément de différenciation, un facteur de correction (c) étant de ce fait attribuable à l'ordinateur supplémentaire (14), en ce que la sortie de l'ordinateur supplémentaire (14) à laquelle la valeur du courant de Foucault ($I_W$) est atteinte, est reliée à une deuxième entrée d'élément soustracteur (7) et en ce que l'élément soustracteur (7) à la sortie duquel l'intensité corrigée ($I_K$) est en attente, est relié au sélecteur (8).

13. Dispositif selon la revendication 12 caractérisé en ce que pour obtenir le facteur de correction (c), le transducteur de force (5) et l'ampèremètre (6b) d'armature de type analogue (2b) sont reliés à un ordinateur de laboratoire (18) pour mémoriser la courbe de l'intensité de courant (I), la variation temporaire d'intensité de courant et la force (K) dans l'opération de commutation pour deux tensions différentes, constantes ($U_1$, $U_2$), pour sélectionner à chaque fois une intensité de courant et une variation temporaire d'intensité de courant pour une force constante (K) pour chacune des deux tensions ($U_1$, $U_2$) et pour calculer le facteur de correction (c) à partir des intensités de courant et des variations temporaires d'intensité de courant pour deux valeurs de tension ($U_1$,$U_2$) et pour une force constante (K) et en ce que la sortie de l'ordinateur de laboratoire (18) est reliée à une mémoire (19) pour le facteur de correction (c) pour rendre disponible le facteur de correction (c).

FIG 1

FIG 3

FIG 2